**Europäisches Patentamt**

(19) **European Patent Office**

**Office européen des brevets**

(11) Veröffentlichungsnummer: **0 279 164 B1**

(12) # EUROPÄISCHE PATENTSCHRIFT

(45) Veröffentlichungstag der Patentschrift:
**14.11.90**

(21) Anmeldenummer: **88100100.2**

(22) Anmeldetag: **07.01.88**

(51) Int. Cl.⁵: **G03F 7/32**

(54) **Von organischen Lösemitteln freies, weitgehend pH-neutrales Entwicklergemisch zum Entwickeln von Flachdruckplatten.**

(30) Priorität: **17.02.87 US 14969**

(43) Veröffentlichungstag der Anmeldung:
**24.08.88 Patentblatt 88/34**

(45) Bekanntmachung des Hinweises auf die Patenterteilung:
**14.11.90 Patentblatt 90/46**

(84) Benannte Vertragsstaaten:
**DE FR GB**

(56) Entgegenhaltungen:
**EP-A- 0 099 003**
**GB-A- 2 183 858**
**US-A- 4 366 224**

**PATENT ABSTRACTS OF JAPAN, Band 9,**
**Nr. 334 (P-417)[2057], 27. Dezember 1985; &**
**JP-A-60 158 461**

(73) Patentinhaber: **HOECHST CELANESE CORPORATION,**
**Route 202-206 North, Somerville, N.J. 08876(US)**

(72) Erfinder: **Hsieh, Shane, 4, Linvale Lane, Bridgewater**
**New Jersey 08807(US)**
Erfinder: **Mitchell, Wayne A., 8, Shydy Lane, Bound**
**Brook New Jersey 08805(US)**

(74) Vertreter: **Euler, Kurt Emil, Dr. et al, HOECHST AG - Werk**
**KALLE Patentabteilung**
**Postfach 3540 Rheingaustrasse 190,**
**D-6200 Wiesbaden(DE)**

**Beschreibung**

Die vorliegende Erfindung betrifft ein Entwicklergemisch zum Entfernen der Nichtbildstellen von belichteten, in der Regel negativ arbeitenden Flachdruckplatten, die aus einem mit einer lichtempfindlichen Schicht versehenen Schichtträger bestehen.

Es wurden in der Vergangenheit verschiedene Verfahren zum Entwickeln von Druckplatten eingesetzt. Z.B. wurden Gemische verwendet, die aus Lösungen von organischen Lösemitteln, Netzmitteln, Salzen, Säuren und anderen aus dem Stand der Technik bekannten Stoffen bestehen.

Es wird angestrebt, ein Entwicklergemisch herzustellen, mit dem die Entwicklung innerhalb kurzer Zeit erfolgen kann. Die oleophilen Bildstellen der Druckplatte sollten dabei farbannehmend und wasserabstoßend sein, während die hydrophilen Nichtbildstellen Wasser annehmen und fette Druckfarbe abstoßen sollten.

Die richtige Auswahl der für die Entwicklerlösung jeweils verwendeten Lösemittel ist von großer Bedeutung. Wenn das eingesetzte Lösemittel für das lichtempfindliche Gemisch selbst gut geeignet ist, findet keine genügende Unterscheidung zwischen den belichteten und den unbelichteten Stellen statt. Infolgedessen wird ein Großteil der Schichtbestandteile der Bildstellen im Lösemittel gelöst oder quillt stark an und löst sich ab. Solche Druckplatten sind unbrauchbar. Durch die Zugabe von Wasser zur Senkung der Lösemittelkonzentration in der Entwicklerlösung kann die Bilddifferenzierung verbessert werden. Während der Entwicklung von Druckplatten, insbesondere von negativ arbeitenden Druckplatten, werden jedoch die an den Nichtbildstellen vorhandenen harzartigen Bindemittel, wie Acetale, insbesondere Polyvinylformal, in der Entwicklerlösung solvatisiert und lösen sich vom Schichtträger ab und ballen sich zu kugeligen, sehr klebrigen Gebilden zusammen. Derartige solvatisierte Partikel lagern sich auf den noch lösemittelfeuchten Bildstellen ab und bleiben dort auch nach dem Trocknen haften. Diese "wiederangelagerten" Stellen sind mit bloßem Auge auf der entwickelten Druckplatte erkennbar und werden überdies von der klebrigen Druckfarbe beim Druckvorgang zusammen mit der eigentlichen, darunterliegenden Bildstelle von der Platte abgerissen, wodurch Löcher entstehen, die auf dem fertigen Druck als bildfreie Stellen erkennbar sind.

Um diesem Problem wenigstens teilweise abzuhelfen, werden in vielen bekannten Entwicklergemischen flüchtige Lösemittel verwendet. Von der Anwesenheit solch flüchtiger Lösemittel in der Entwicklerlösung erhofft man sich, daß durch eine rasche Verdampfung des Lösemittels das Klebrigwerden der Bildstellen verhindert wird. Die Verwendung großer Mengen wasserlöslicher Lösemittel mit niedrigem Siedepunkt, deren Einsatz z.B. im Entwickler gemäß der US-A 3 954 472 vorgeschlagen wird, führt jedoch zu Problemen im Hinblick auf mögliche Gesundheitsgefährdungen am Arbeitsplatz, Sicherheitsrisiken aufgrund des niedrigen Flammpunktes und Umweltbelastungen. Durch eine Senkung der Konzentration dieser wasserlöslichen Lösemittel mit niedrigem Siedepunkt können diese Probleme zwar auf ein Minimum reduziert werden, doch verlängert sich gleichzeitig die Entwicklungszeit. Die Klebrigkeit der Schichten wird zwar verringert, kann aber nicht völlig ausgeschaltet werden.

Um die für die Entwicklung benötigte Zeit bei der Verwendung von Entwicklerlösungen mit einem geringeren Gehalt an niedrigsiedenden Lösemitteln abzukürzen, werden in einigen Fällen höhersiedende organische Lösemittel als Hilfsmittel eingesetzt. Derartige Entwickler weisen jedoch ebenfalls etliche Nachteile auf, wie z.B. Toxizität, geringere Entwicklerstabilität, Geruchsbelästigung oder Unvermögen, den Bildhintergrund an den Nichtbildstellen vollständig freizulegen.

Flachdruckplatten bestehen im allgemeinen aus einem Schichtträger auf Aluminiumbasis, der gegebenenfalls mit Hilfe eines der vielen bekannten Verfahren vorbehandelt wurde, z. B. durch verschiedene Aufrauhverfahren, anodische Oxidation oder Hydrophilierung. Auf den entsprechend vorbereiteten Schichtträger wird eine lichtempfindliche Schicht aus einer lichtempfindlichen Verbindung, harzartigen Bindemitteln, Farbmitteln, stabilisierenden Säuren, Netzmitteln und anderen bekannten Bestandteilen aufgetragen. Zu den üblicherweise verwendeten lichtempfindlichen Verbindungen zählen Diazoniumverbindungen, wie polymere Diazoniumsalzkondensationsprodukte und photopolymerisierbare Gemische. Lichtempfindliche Verbindungen, Bindemittel und Druckplatten, für deren Herstellung aromatische Diazoniumverbindungen verwendet werden, sind beispielsweise aus den US-A 3 175 906, 3 046 118, 2 063 631, 2 667 415, 3 867 147 und 3 679 419 bekannt.

Typische, zum Stand der Technik zählende Entwicklergemische sind in den US-A 2 754 279 und 4 381 340 sowie in der DE-A 2 216 419 beschrieben.

In der GB-A 2 183 858 wird ein Entwickler für negativ arbeitende lichtempfindliche Schichten beschrieben, der a) Wasser, b) Natrium- oder Kaliumsalze von Hydroxiden, Silikaten und Sulfaten etc., c) oberflächenaktive Verbindungen wie Alkali- oder Ammoniumalkylsulfate sowie gegebenenfalls d) Zitronensäure oder deren Salze und e) Hydrogencarbonat enthält.

In der US-A 4 366 224 wird ein Entwickler für positiv arbeitende lichtempfindliche Gemische vorgestellt, anwendbar für Druckplatten oder Photoresists, der eine wäßrige Lösung eines anorganischen Lithiumsalzes, wie dessen Hydroxide, Chloride, Bromide, Nitrate, Carbonate oder Sulfate, in Kombination mit Natriummetasilikat enthält.

Die JP-A 60 158 461 hat einen Entwickler für Photoresists auf der Basis von von 1,2-Naphthochinondiaziden zum Gegenstand, der $\geq 0,05\%$ und $\leq 1\%$ eines organischen Lösemittels, z.B. eines Alkohols, Esters oder Ketons, in Kombination mit einer wäßrigen Lösung aus anorganischen Alkalisalzen, Ammoniak oder einer organischen Base enthält.

In der EP-A 0 099 003 wird ein Entwickler beschrieben, der einen alkalischen pH-Wert von 8 bis 12 aufweist. Er enthält a) ein Alkalisalz eines Schwefelsäureesters eines Alkohols, b) ein Alkali- oder Ammoniummetasilikat, c) ein Alkali- oder Ammoniumborat, d) eine Alkandicarbonsäure oder eines ihrer Salze sowie e) ein Alkaliphosphat.

Aufgabe der Erfindung ist es, ein von organischen Lösemitteln freies Entwicklergemisch für Flachdruckplatten vorzuschlagen, das die erwähnten Nachteile bekannter Entwickler für Flachdruckplatten nicht aufweist, im wesentlichen pH-neutral ist und eine wirtschaftlich und technisch befriedigende Entfernung der Nichtbildstellen gewährleistet.

Die Aufgabe wird erfindungsgemäß gelöst durch ein von organischen Lösemitteln freies Entwicklergemisch, das einen pH-Wert zwischen 6, 5 und 7, 5 aufweist, enthaltend

a) 0,1 bis 20 Gew.-%, bezogen auf das Gesamtgewicht des Entwicklers, mindestens einer Verbindung aus der Gruppe umfassend Natriumoctylsulfat, Natriumtetradecylsulfat, Natrium-2-ethyl-hexylsulfat und Ammoniumlaurylsulfat,

b) 0,1 bis 30 Gew.-%, bezogen auf das Gesamtgewicht des Entwicklers, mindestens einer Verbindung aus der Gruppe umfassend die Lithiumsalze der Hydroxy-, Aryl- und Alkylcarbonsäuren,

c) 0,1 bis 30 Gew.-%, bezogen auf das Gesamtgewicht des Entwicklers, mindestens einer Verbindung aus der Gruppe umfassend die Kaliumsalze der Hydroxy-, Aryl- und Alkylcarbonsäuren,

d) gegebenenfalls eine organische oder anorganische, mit dem übrigen Gemisch kompatible Säure oder Base, in einer jeweils zur Einstellung des Entwicklergemischs auf einen pH-Wert zwischen 6,5 und 7,5 ausreichenden Menge,

e) gegebenenfalls bis zu 0,05 Gew.-%, bezogen auf das Gesamtgewicht des Entwicklers, eines Entschäumungsmittels sowie

f) Rest an Wasser bis zu einer Gesamtmenge von 100 Gew.-%.

Erfindungsgemäß wird ferner ein Verfahren zur Herstellung eines Reliefbildes vorgeschlagen, bei dem eine Druckplatte, bestehend aus einem Träger und darauf aufgebrachter, positiv oder negativ arbeitender lichtempfindlicher Schicht mittels aktinischer Strahlung belichtet wird, so daß ein latentes Bild entsteht, und anschließend die Nichtbildstellen von dem belichteten Material mit einem von organischen Lösemitteln freien Entwicklergemisch entfernt werden, das einen pH-Wert zwischen 6,5 und 7,5 aufweist, enthaltend

a) 0,1 bis 20 Gew.-%, bezogen auf das Gesamtgewicht des Entwicklers, mindestens einer Verbindung aus der Gruppe umfassend Natriumoctylsulfat, Natriumtetradecylsulfat, Natrium-2-ethyl-hexylsulfat und Ammoniumlaurylsulfat,

b) 0,1 bis 30 Gew.-%, bezogen auf das Gesamtgewicht des Entwicklers, mindestens einer Verbindung aus der Gruppe umfassend die Lithiumsalze der Hydroxy-, Aryl- und Alkylcarbonsäuren,

c) 0,1 bis 30 Gew.-%, bezogen auf das Gesamtgewicht des Entwicklers, mindestens einer Verbindung aus der Gruppe umfassend die Kaliumsalze der Hydroxy-, Aryl- und Alkylcarbonsäuren,

d) gegebenenfalls eine organische oder anorganische, mit dem übrigen Gemisch kompatible Säure oder Base, in einer jeweils zur Einstellung des Entwicklergemischs auf einen pH-Wert zwischen 6,5 und 7,5 ausreichenden Menge,

e) gegebenenfalls bis zu 0,05 Gew.-%, bezogen auf das Gesamtgewicht des Entwicklers, eines Entschäumungsmittels sowie

f) Rest an Wasser bis zu einer Gesamtmenge von 100 Gew.-%.

Bei der Herstellung negativ arbeitender lichtempfindlicher Materialien, wie z. B. Flachdruckplatten, wird zunächst ein blattförmiger Träger, der beispielsweise aus zur Herstellung von Flachdruckplatten geeigneten Aluminiumlegierungen wie Alcoa® 3003 oder Alcoa® 1100 besteht und gegebenenfalls auf übliche Weise, z.B. durch mechanisches oder elektrolytisches Aufrauhen und/oder Ätzen und/oder anodische Oxidation vorbehandelt und gegebenenfalls außerdem mit einem als Hydrophilierungsmittel für Flachdruckplatten geeigneten Gemisch, wie z.B. Polyvinylphosphonsäure, behandelt wurde, mit einem lichtempfindlichen Gemisch beschichtet, das als lichtempfindliche Verbindung ein polymeres Diazoniumsalz oder ein Photopolymeres enthält. Dieses Gemisch kann außerdem harzförmige Bindemittel, wie Polyvinylformalharze, Farbmittel, stabilisierende Säuren, Netzmittel Belichtungsindikatoren oder andere bekannte Zusätze enthalten.

Anschließend wird das lichtempfindliche blattförmige Material mittels einer geeigneten Strahlungsquelle durch eine Maske oder Transparentvorlage belichtet und die belichtete Platte zur Entfernung der lichtempfindlichen Beschichtung von den Nichtbildstellen entwickelt.

Das lichtempfindliche Beschichtungsgemisch wird gewöhnlich als Gemisch in einem Lösemittelsystem hergestellt, das mit allen übrigen Bestandteilen verträglich ist. Der Schichtträger wird mit diesem lichtempfindlichen Gemisch beschichtet, und das Lösemittel wird verdampft.

Die Diazoniumverbindungen, die im Rahmen dieser Erfindung für die Herstellung lichtempfindlicher Gemische am häufigsten verwendet werden, entsprechen der allgemeinen Formel $A-N_2^+X^-$, in der A ein aromatischer oder heterozyklischer Rest und X das Anion einer Säure ist.

Zu den für die vorstehend genannten Zwecke geeigneten lichtempfindlichen Diazoniummaterialien gehören insbesondere höhermolekulare Gemische, die z. B. durch die Kondensation bestimmter aromatischer Diazoniumsalze in einem sauren Medium mit bestimmten aromatischen Carbonylverbindungen wie Formaldehyd erhalten werden, wie es beispielsweise in den US-A 2 063 631 und 2 667 415 beschrieben ist. Eine Gruppe bevorzugt eingesetzter Diazoniumverbindungen, ist in der US-A 3 849 392 beschrieben. Besonders bevorzugt wird unter den Diazoniumsalzen das aus der US-A 3 849 392 bekannte, als Mesitylensulfonat ausgefällte Polykondensationsprodukt aus 3-Methoxy-4-diazodiphenylaminsulfat und 4,4'-Bismethoxymethyldiphenylether.

3

Geeignete photopolymerisierbare Gemische sind dem Fachmann bekannt.

Die vorliegende Erfindung sieht ein Verfahren zum Entwickeln derartiger belichteter, lichtempfindlicher Materialien vor, in dem zum Entfernen der Nichtbildstellen ein Entwickler verwendet wird, der die erwähnten Bestandteile in wäßriger Lösung enthält. Das Entwicklergemisch ist im wesentlichen pH-neutral, d. h., sein pH-Wert liegt zwischen 6,5 und 7,5, bevorzugt zwischen 6,5 und 7,2 und insbesondere zwischen 7,0 und 7,2.

Als Netzmittelkomponente enthält der Entwickler ein Alkylsulfat, bei dessen Verwendung im erfindungsgemäßen Entwickler keine wesentliche Schaumbildung auftritt. Die Netzmittelkomponente wird durch eine oder mehrere Verbindungen aus der Gruppe umfassend Natriumoctylsulfat, Natriumtetradecylsulfat, Natrium-2-ethyl-hexylsulfat und Ammoniumlaurylsulfat gebildet. Ihr Anteil am Entwicklergemisch beträgt 0,1 bis 20 Gew.-%, bevorzugt 0,5 bis 15 Gew.-%, und insbesondere 1,0 bis 8 Gew.-%.

Das Entwicklergemisch enthält außerdem 0,1 bis 30 Gew.-%, bevorzugt 1 bis 20 Gew.-%, insbesondere 5 bis 10 Gew.-% mindestens eines Lithiumsalzes einer Hydroxy- Aryl- oder Alkylcarbonsäure, z. B. Lithiumbenzoate. Das gewünschte Salz kann auch durch Zugabe von Lithiumhydroxid zu einer wäßrigen Lösung der jeweiligen Carbonsäure gebildet werden.

Ferner sind im erfindungsgemäßen Entwicklergemisch 0,1 bis 30 Gew.-%, bevorzugt 0,5 bis 20 Gew.-%, insbesondere 1 bis 10 Gew.-% eines Kaliumsalzes einer Hydroxy-, Alkyl- oder Arylcarbonsäure enthalten. Dazu gehören beispielsweise Kaliumsorbat, Kaliumcitrat, Kaliumsuccinat und Kaliummalat. Diese Substanzen sind im Handel erhältlich, sie können aber auch durch Zugabe von Kaliumhydroxid zu einer Lösung der jeweiligen Carbonsäure selbst hergestellt werden. Als Beispiele hierfür geeigneter Carbonsäuren seien Sorbin-, Bernstein-, Benzoe-, DL.-Apfel-, Wein- und Citronensäure genannt.

Gegebenenfalls enthält das Entwicklergemisch als weitere Komponente eine Säure oder Base, die zur Einstellung des erfindungsgemäß erwünschten pH-Bereiches in entsprechender Menge zugegeben wird. Hierfür eignen sich beispielsweise DL.-Glycerinsäure, Apfelsäure, Weinsäure, Bernsteinsäure, Citronensäure, Milchsäure, Laurinsäure, 8,9,15-Trihydroxypalmitinsäure sowie Alkalihydroxide.

Bevorzugt enthält der erfindungsgemäße Entwickler zur Erleichterung der Druckplattenverarbeitung von Fall zu Fall auch geringe Mengen eines üblichen Entschäumungsmittels. Dieses wird dann in einer Menge von 0,02 bis 0,05 Gew.-%, bezogen auf das Gesamtgewicht des Entwicklers, zugesetzt.

Die erfindungsgemäße Entwicklerlösung wird im praktischen Gebrauch häufig in Verarbeitungsgeräten eingesetzt, in denen es zu einer Verunreinigung der Lösung durch abgelöste Schichtbestandteile kommen kann. Als Folge davon können im Laufe der Zeit unerwünschte pH-Wert-Schwankungen auftreten. Daher ist es vorteilhaft, dem Entwickler gegebenenfalls eine Puffersubstanz beizumischen.

Bevorzugt werden diese Substanzen in einer Menge zugesetzt, die ausreicht, um pH-Wert-Abweichungen von mehr als ±2 gegenüber der nicht verunreinigten Entwicklerlösung zu verhindern. Als Beispiele für geeignete derartige Substanzen seien die Alkalisalze der Citronen-, Phosphor-, Bor-, Barbitur-, Bernstein- und Phthalsäure sowie Triethanolamin und Tris(hydroxymethyl)aminoethan genannt. Aus Gründen des Umweltschutzes werden die Alkaliphosphate jedoch trotz ihrer guten Pufferwirkung bevorzugt nicht verwendet. Die am meisten bevorzugte Puffersubstanz ist Natriumcitrat.

Ein bevorzugt eingesetztes Entschäumungsmittel ist beispielsweise Dow® DB-31, ein Mittel auf Silikonbasis. Außerdem enthält der Entwickler Wasseranteile bis zu einer Gesamtmenge von 100 Gew.-%.

Wie erwähnt, können dem Gemisch zur Einstellung des pH-Wertes auf den gewünschten Bereich gegebenenfalls auch geringe Mengen einer kompatiblen Säure oder Base beigemischt werden. Gegebenenfalls kann der Entwickler auch Filmbildner enthalten. Mit Hilfe des erfindungsgemäßen Entwicklergemisches lassen sich die Nichtbildstellen von einem lichtempfindlichen Material innerhalb eines Zeitraums von höchstens 2 Minuten vollständig entfernen, ohne daß merkliche Teile der Bildstellen mitentfernt werden. Es wird praktisch keine Wiederanlagerung der von den Nichtbildstellen entfernten Schichtteile auf dem Material festgestellt.

Die Erfindung wird anhand der folgenden Beispiele näher erläutert, ohne daß jedoch eine Einschränkung auf die Beispiele bestehen soll.

### Beispiel 1

Eine negativ arbeitende Druckplatte vom Typ ENCO®N-25, Hersteller: Hoechst Celanese Corporation, wird mittels aktinischer Strahlung in bekannter Weise bildmäßig belichtet. Die belichtete Platte wird mit einem Entwicklergemisch folgender Zusammensetzung ausgewaschen:

3,00 Gew.-% Natriumoctylsulfat,
6,00 Gew.-% Lithiumbenzoat,
4,00 Gew.-% Kaliumsorbat,
1,00 Gew.-% Natriumcitrat,
0,10 Gew.-% Citronensäure,
0,02 Gew.-% Dow® DB-31 und
85,88 Gew.-% Wasser,

Die Platte läßt sich sauber entwickeln, ohne daß es zu merklichen Tonerscheinungen an den Bildhintergrundstellen oder zu Wiederanlagerungen von abgelösten Schichtteilen kommt.

### Beispiel 2

Beispiel 1 wird wiederholt, mit dem Unterschied, daß der verwendete Entwickler folgende Zusammensetzung hat:

3,00 Gew.-% Natriumoctylsulfat,
7,00 Gew.-% Lithiumbenzoat,
4,00 Gew.-% Kaliummalat,

0,02 Gew.-% Dow® DB-31 und
85,98 Gew.-% Wasser.

Die Ergebnisse entsprechen denen von Beispiel 1.

Beispiel 3

Beispiel 1 wird wiederholt, mit dem Unterschied, daß der verwendete Entwickler folgende Zusammensetzung hat:

3,50 Gew.-% Natriumoctylsulfat,
7,50 Gew.-% Lithiumbenzoat,
2,50 Gew.-% Kaliumbenzoat,
1,00 Gew.-% Natrium-2-hydroxybutyrat,
0,02 Gew.-% Dow® DB-31 und
85,48 Gew.-% Wasser.

Die Ergebnisse entsprechen denen von Beispiel 1.

Beispiel 4

Beispiel 1 wird wiederholt, mit dem Unterschied, daß der verwendete Entwickler folgende Zusammensetzung hat:

7,50 Gew.-% Lithiumsuccinat,
1,00 Gew.-% Bernsteinsäure,
1,00 Gew.-% Kaliumhydroxid,
3,00 Gew.-% Natriumoctylsulfat,
0,02 Gew.-% Dow® DB-31 und
87,48 Gew.-% entionisiertes Wasser.

Die Ergebnisse entsprechen denen von Beispiel 1.

Beispiel 5

Beispiel 1 wird wiederholt, mit dem Unterschied, daß der verwendete Entwickler folgende Zusammensetzung hat:

5,75 Gew.-% Weinsäure,
2,58 Gew.-% Lithiumhydroxid,
1,27 Gew.-% Kaliumhydroxid,
3,00 Gew.-% Natriumoctylsulfat,
0,02 Gew.-% Dow® DB-31 und
87,38 Gew.-% entionisiertes Wasser.

Die Ergebnisse entsprechen denen von Beispiel 1.

Beispiel 6

Beispiel 1 wird wiederholt, mit dem Unterschied, daß der verwendete Entwickler folgende Zusammensetzung hat:

7,50 Gew.-% Lithiumcitrat,
2,50 Gew.-% Kaliumcitrat,
0,09 Gew.-% Citronensäure,
3,00 Gew.-% Natriumoctylsulfat,
0,02 Gew.-% Dow® DB-31 und
86,89 Gew.-% entionisiertes Wasser.

Die Ergebnisse entsprechen denen von Beispiel 1.

Beispiel 7

Beispiel 1 wird wiederholt, mit dem Unterschied, daß der verwendete Entwickler folgende Zusammensetzung hat:

7,50 Gew.-% Lithiumbenzoat,
2,20 Gew.-% Kaliumcitrat,
3,00 Gew.-% Natriumoctylsulfat, 2 Tropfen Salzsäure,
Rest zu 100 Gew.-% entionisiertes Wasser.

Die Ergebnisse entsprechen denen von Beispiel 1.

Beispiel 8

Beispiel 1 wird wiederholt, mit dem Unterschied, daß der verwendete Entwickler folgende Zusammensetzung hat:

3,00 Gew.-% Natriumoctylsulfat,
7,50 Gew.-% Lithiumbenzoat,
1,38 Gew.-% Kaliumhydroxid,
1,35 Gew.-% Citronensäure, wasserfrei,
0,03 Gew.-% Dow® DB-31 und
86,74 Gew.-% Wasser.

Die Ergebnisse entsprechen denen von Beispiel 1.

Beispiel 9

Beispiel 1 wird wiederholt, mit dem Unterschied, daß der verwendete Entwickler folgende Zusammensetzung hat:

7,50 Gew.-% Lithiumbenzoat,
2,50 Gew.-% Kaliumbenzoat,
3,00 Gew.-% Natriumoctylsulfat,
2 Tropfen Salzsäure,
0,02 Gew.-% Dow® DB-31 und
86,98 Gew.-% entionisiertes Wasser.

Die Ergebnisse entsprechen denen von Beispiel 1.

Beispiel 10

Beispiel 1 wird wiederholt, mit dem Unterschied, daß der verwendete Entwickler folgende Zusammensetzung hat:

7,50 Gew.-% Lithiumbenzoat,
1,50 Gew.-% Kaliumhydroxid,
1,50 Gew.-% DL.-Apfelsäure,
3,00 Gew.-% Natriumoctylsulfat,
0,02 Gew.-% Dow® DB-31 und
86,48 Gew.-% entionisiertes Wasser.

Die Ergebnisse entsprechen denen von Beispiel 1.

Beispiel 11

Beispiel 1 wird wiederholt, mit dem Unterschied, daß der verwendete Entwickler folgende Zusammensetzung hat:

5,75 Gew.-% DL.-Apfelsäure,
2,50 Gew.-% Lithiumhydroxid,
1,50 Gew.-% Kaliumhydroxid,
3,00 Gew.-% Natriumoctylsulfat,
0,02 Gew.-% Dow® DB-31 und
87,23 Gew.-% entionisiertes Wasser.

Die Ergebnisse entsprechen denen von Beispiel 1.

## Patentansprüche

1. Von organischen Lösemitteln freies Entwicklergemisch mit einem pH-Wert von etwa 6,5 bis 7,5 zum Entwickeln von Flachdruckplatten, enthaltend
   a) 0,1 bis 20 Gew.-%, bezogen auf das Gesamtgewicht des Entwicklers, mindestens einer Verbindung aus der Gruppe umfassend Natriumoctylsulfat, Natriumtetradecylsulfat, Natrium-2-ethylhexylsulfat und Ammoniumlaurylsulfat,
   b) 0,1 bis 30 Gew.-%, bezogen auf das Gesamtgewicht des Entwicklers, mindestens einer Verbindung aus der Gruppe umfassend die Lithiumsalze der Hydroxy-, Aryl- und Alkylcarbonsäuren,
   c) 0,1 bis 30 Gew.-%, bezogen auf das Gesamtgewicht des Entwicklers, mindestens einer Verbindung aus der Gruppe umfassend die Kaliumsalze der Hydroxy-, Aryl- und Alkylcarbonsäuren,
   d) gegebenenfalls eine organische oder anorganische, mit dem übrigen Gemisch kompatible Säure oder Base, in einer jeweils zur Einstellung des Entwicklergemischs auf einen pH-Wert zwischen 6,5 und 7,5 ausreichenden Menge,
   e) gegebenenfalls bis zu 0,05 Gew.-%, bezogen auf das Gesamtgewicht des Entwicklers, eines Entschäumungsmittels sowie
   f) Rest an Wasser bis zu einer Gesamtmenge von 100 Gew.-%.

2. Entwicklergemisch nach Anspruch 1, dadurch gekennzeichnet, daß die Komponente a) Natriumoctylsulfat ist.

3. Entwicklergemisch nach einem der Ansprüche 1 oder 2, dadurch gekennzeichnet, daß die Komponente b) Lithiumbenzoat ist.

4. Entwicklergemisch nach einem der Ansprüche 1 bis 3, dadurch gekennzeichnet, daß die Komponente c) Kaliumsorbat ist.

5. Entwicklergemisch nach einem der Ansprüche 1 bis 4, dadurch gekennzeichnet, daß die Komponente d) eine oder mehrere Säure(n) der Gruppe aus Citronen-, Phosphor-, Bor-, Barbitur-, Bernstein-, Milch- oder Laurinsäure oder 8, 9, 15-Trihydroxypalmitinsäure, Palmitinsäure oder Alkalihydroxide enthält.

6. Entwicklergemisch nach einem der Ansprüche 1 bis 5, dadurch gekennzeichnet, daß die Komponente d) Citronensäure ist.

7. Entwicklergemisch nach einem der Ansprüche 1 bis 6, dadurch gekennzeichnet, daß es ein Entschäumungsmittel in einer Menge von 0,02 bis 0,05 Gew.-%, bezogen auf das Gesamtgewicht des Entwicklers, enthält.

8. Entwicklergemisch nach einem der Ansprüche 1 bis 7, dadurch gekennzeichnet, daß es zusätzlich eine Puffersubstanz enthält.

9. Entwicklergemisch nach Anspruch 8, dadurch gekennzeichnet, daß die Puffersubstanz aus Alkalisalzen von Citronen-, Phosphor-, Bor-, Barbitur-, Bernstein- oder Phthalsäure oder Triethanolamin oder Tris(hydroxymethyl)aminoethan oder Gemischen davon besteht.

10. Entwicklergemisch nach Anspruch 9, dadurch gekennzeichnet, daß die Puffersubstanz Natriumcitrat ist.

11. Entwicklergemisch nach einem der Ansprüche 1 bis 10, dadurch gekennzeichnet, daß die Komponente a) mit einem Anteil von 0,5 bis 20 Gew.-% vorhanden ist.

12. Entwicklergemisch nach einem der Ansprüche 1 bis 11, dadurch gekennzeichnet, daß die Komponente b) in einem Anteil von 0,5 bis 20,0 Gew.-% vorhanden ist.

13. Entwicklergemisch nach einem der Ansprüche 1 bis 12, dadurch gekennzeichnet, daß die Komponente c) in einem Anteil von 0,5 bis 20,0 Gew.-% vorhanden ist.

14. Entwicklergemisch nach einem der Ansprüche 1 bis 13, dadurch gekennzeichnet, daß die Komponente a) in einem Anteil von 1,0 bis 8,0 Gew.-%, die Komponente b) in einem Anteil von 5 0 bis 10,0 Gew.-% und die Komponente c) in einem Anteil von 1,0 bis 10,0 Gew.-% vorhanden ist.

15. Entwicklergemisch nach einem der Ansprüche 1 bis 14, bestehend aus 1,0 bis 8,0 Gew.-% Natriumoctylsulfat, 5,0 bis 10,0 Gew.-% Litniumbenzoat, 1,0 bis 10,0 Gew.-% Kaliumsorbat und Zitronensäure sowie Rest bis zu 100 Gew.-% Wasser.

16. Verwendung des Entwicklergemisches nach einem der Ansprüche 1 bis 15 zur Entwicklung von belichteten, negativ arbeitenden Flachdruckplatten, insbesondere solchen mit Aluminium als Träger.

## Claims

1. Developer mixture, free from organic solvents and having a pH of about 6.5 to 7.5, for developing planographic printing plates and containing
   a) 0.1 to 20% by weight, relative to the total weight of the developer, of at least one compound from the group comprising sodium octyl sulphate, sodium tetradecylsulphate, sodium 2-ethylhexylsulphate and ammonium laurylsulphate,
   b) 0.1 to 30% by weight, relative to the total weight of the developer, of at least one compound from the group comprising the lithium salts of hydroxycarboxylic, arylcarboxylic and alkylcarboxylic acids,
   c) 0.1 to 30% by weight, relative to the total weight of the developer, of at least one compound from the group comprising the potassium salts of hydroxycarboxylic, arylcarboxylic and alkylcarboxylic acids,
   d) if appropriate an organic or inorganic acid or base which is compatible with the remaining mixture in each case in an amount sufficient to adjust the pH of the developer mixture to a value between 6.5 and 7.5,
   e) if appropriate up to 0.05% by weight, relative to the total weight of the developer, of an antifoaming agent, and

f) a remainder of water up to a total amount of 100% by weight.

2. Developer mixture according to claim 1, characterized in that the component a) is sodium octyl sulphate.

3. Developer mixture according to one of claims 1 or 2, characterized in that the component b) is lithium benzoate.

4. Developer mixture according to one of claims 1 to 3, characterized in that the component c) is potassium sorbate.

5. Developer mixture according to one of claims 1 to 4, characterized in that the component d) contains one or more acid(s) of the group comprising citric, phosphoric, boric, barbituric, succinic, lactic or lauric acid, or 8,9,15-trihydroxypalmitic acid, palmitic acid or alkali metal hydroxides.

6. Developer mixture according to one of claims 1 to 5, characterized in that the component d) is citric acid.

7. Developer mixture according to one of claims 1 to 6, characterized in that it contains an anti-foaming agent in an amount of 0.02 to 0.05% by weight, relative to the total weight of the developer.

8. Developer mixture according to one of claims 1 to 7, characterized in that it contains in addition a buffer substance.

9. Developer mixture according to claim 8, characterized in that the buffer substance consists of alkali metalsalts of citric, phosphoric, boric, barbituric, succinic or phthalic acid, or triethanolamine or tris(hydroxymethyl)aminoethane or mixtures thereof.

10. Developer mixture according to claim 9, characterized in that the buffer substance is sodium citrate.

11. Developer mixture according to one of claims 1 to 10, characterized in that the component a) is present in a proportion of 0.5 to 20% by weight.

12. Developer mixture according to one of claims 1 to 11, characterized in that the component b) is present in a proportion of 0.5 to 20.0% by weight.

13. Developer mixture according to one of claims 1 to 12, characterized in that the component c) is present in a proportion of 0.5 to 20.0% by weight.

14. Developer mixture according to one of claims 1 to 13, characterized in that the component a) is present in a proportion of 1.0 to 8.0% by weight, the component b) is present in a proportion of 5.0 to 10.0% by weight and the component c) is present in a proportion of 1.0 to 10.0% by weight.

15. Developer mixture according to one of claims 1 to 14, consisting of 1.0 to 8.0% by weight of sodium octyl sulphate, 5.0 to 10.0% by weight of lithium benzoate, 1.0 to 10.0% by weight of potassium sorbate and citric acid as well as a remainder of up to 100% by weight of water.

16. The use of the developer mixture according to one of claims 1 to 15, for developing exposed, negatively operating planographic printing plates, in particular plates having aluminium as the support.

## Revendications

1. Composition de développement exempte de solvants organiques ayant un pH compris entre environ 6,5 et 7,5, et contenant

a) de 0,1 à 20% en poids, par rapport au poids total du révélateur, d'au moins un composé choisi parmi l'octylsulfate de sodium, le tétradécylsulfate de sodium, le 2-éthylhexylsulfate de sodium et le laurylsulfate d'ammonium;

b) de 0,1 à 30% en poids, par rapport au poids total du révélateur, d'au moins un composé choisi parmi les sels de lithium des acides hydroxy-, aryl- et alkylcarboxyliques;

c) de 0,1 à 30% en poids, par rapport au poids total du révélateur, d'au moins un composé choisi parmi les sels de potassium des acides hydroxy-, aryl- et alkylcarboxyliques;

d) éventuellement un acide ou une base organique ou inorganique, compatible avec la composition restante, en une quantité suffisante dans chaque cas pour l'ajustement de la composition de développement à un pH compris entre 6,5 et 7,5;

e) éventuellement jusqu'à 0,05% en poids, par rapport au poids total du révélateur, d'un agent antimousse, ainsi que

f) le reste en eau, jusqu'à une quantité totale de 100% en poids.

2. Composition de développement selon la revendication 1, caractérisée en ce que le composant a) est l'octylsulfate de sodium.

3. Composition de développement selon la revendication 1 ou 2, caractérisée en ce que le composant b) est le benzoate de lithium.

4. Composition de développement selon l'une des revendications 1 à 3, caractérisée en ce que le composant c) est le sorbate de potassium.

5. Composition de développement selon l'une des revendications 1 à 4, caractérisée en ce que le composant d) contient un ou plusieurs acides choisis parmi les acides citrique, phosphorique, borique, barbiturique, succinique, lactique ou laurique ou l'acide 8,9,15-trihydroxypalmitique, l'acide palmitique ou des hydroxydes de métaux alcalins.

6. Composition de développement selon l'une des revendications 1 à 5, caractérisée en ce que le composant d) est l'acide citrique.

7. Composition de développement selon l'une des revendications 1 à 6, caractérisée en ce qu'elle contient un agent antimousse en une quantité de 0,02 à 0,05 partie en poids, par rapport au poids total de la composition de développement.

8. Composition de développement selon l'une des revendications 1 à 7, caractérisée en ce qu'elle contient en outre une substance tampon.

9. Composition de développement selon la revendication 8, caractérisée en ce que la substance tampon est constituée de sels alcalins de l'acide citrique, phosphorique, borique, barbiturique, succinique ou phtalique, ou de la triéthanolamine ou du tris(hydroxyméthyl)aminoéthane ou de mélanges de ceux-ci.

10. Composition de développement selon la revendication 9, caractérisée en ce que la substance tampon est le citrate de sodium.

11. Composition de développement selon l'une des revendications 1 à 10, caractérisée en ce que le composant a) est présent en une proportion de 0,5 à 20% en poids.

12. Composition de développement selon l'une des revendications 1 à 11, caractérisée en ce que le composant b) est présent en une proportion de 0,5 à 20,0% en poids.

13. Composition de développement selon l'une des revendications 1 à 12, caractérisée en ce que le composant c) est présent en une proportion de 0,5 à 20,0% en poids.

14. Composition de développement selon l'une des revendications 1 à 13, caractérisée en ce que le composant a) est présent en une proportion de 1,0 à 8,0% en poids, le composant b) est présent en une proportion de 5,0 à 10,0% en poids et le composant c) est présent en une proportion de 1,0 à 10,0% en poids.

15. Composition de développement selon l'une des revendications 1 à 14, constituée de 1,0 à 8,0% en poids d'octylsulfate de sodium, de 5,0 à 10,0% en poids de benzoate de lithium, de 1,0 à 10,0% en poids de sorbate de potassium et d'acide citrique, et d'eau en complément jusqu'à 100% en poids.

16. Utilisation de la composition de développement selon l'une des revendications 1 à 15, pour le développement de plaques d'impression à plat travaillant en négatif, exposées, en particulier, de celles comportant de l'aluminium en tant que support.